# FASCICULE DE BREVET EUROPEEN

(11) **EP 3 867 082 B1**
(45) Date de publication et mention de la délivrance du brevet: **22.05.2024**
(21) Numéro de dépôt: 19808865.0
(22) Date de dépôt: 17.10.2019
(51) Int. Cl.: B60C 99/00, G01M 17/02

(54) **PROCEDE DE SIMULATION DE L'EVOLUTION TEMPORELLE D'UN SYSTEME PHYSIQUE EN TEMPS REEL**
SIMULATIONSVERFAHREN DES ZEITLICHEN VERLAUFES EINES PHYSIKALISCHEN SYSTEMS IN ECHTZEIT
SIMULATION METHOD OF THE TEMPORAL EVOLUTION OF A PHYSICAL SYSTEM IN REAL TIME

(30) Priorité: 19.10.2018 FR 1859687
(43) Date de publication de la demande: 25.08.2021
(73) Titulaire: COMPAGNIE GENERALE DES ETABLISSEMENTS MICHELIN, 63000 Clermont-Ferrand (FR)
(72) Inventeur: VAYSSETTES, Jérémy, 63040 CLERMONT-FERRAND CEDEX 9 (FR); GAUCHEZ, Romain, 63040 CLERMONT-FERRAND CEDEX 9 (FR); HEINRY, Carole, 63040 CLERMONT-FERRAND (FR)
(74) Mandataire: M.F.P. Michelin
(86) Numéro de dépôt international: PCT/FR2019/052467
(87) Numéro de publication internationale: WO 2020/079376

(56) Documents cités:
- WO-A1-2008/025892
- FR-A1- 2 905 496

## Description

### 1. Domaine de l'invention

L'invention concerne le domaine de la simulation de l'évolution de systèmes physiques en temps réel. Elle concerne en particulier un procédé de simulation du comportement physique d'un pneu équipant un véhicule.

### 2. Art antérieur

L'invention se situe dans le cadre d'un perfectionnement du logiciel TameTire (marque déposée de la Compagnie Générale des Etablissements Michelin) mettant en oeuvre un procédé de simulation du comportement physique d'un pneu équipant un véhicule en roulage sur le sol. Le procédé est décrit en détail dans le document brevet FR 2 905 496. Le procédé permet en particulier de calculer en temps réel des efforts longitudinaux, des efforts transversaux et un couple d'auto-alignement du pneu. Le couple d'auto-alignement est le couple s'exerçant sur le pneu à l'interface avec le sol, autour d'un axe Z passant par le centre de l'aire de contact, orthogonal à la surface du sol et pointant vers le haut.

Le calcul de ces efforts implique la résolution de systèmes d'équations aux dérivées partielles. La résolution de ces systèmes d'équations nécessite la mise en oeuvre de méthodes de calcul non-linéaires fondées sur la convergence d'un algorithme itératif. En d'autres termes, le calcul de ces efforts à chaque période d'échantillonnage requiert plusieurs itérations de calcul.

Pour certaines applications, par exemple dans le cadre de simulateurs de conduite, le calcul doit être fait en temps réel. Ceci implique qu'à chaque période d'échantillonnage de la simulation, le calcul des grandeurs doit être terminé afin de satisfaire les contraintes temps réel et d'assurer un bon fonctionnement de la simulation. Pour des fréquences d'échantillonnage élevées, la période d'échantillonnage de la simulation est faible, par exemple de l'ordre de 0.001 ms pour les simulateurs de conduite. Ainsi, une seule période n'est souvent pas suffisante pour permettre à des modèles fonctionnels thermomécaniques tels que TameTire de converger vers des valeurs d'efforts suffisamment précises.

Dans de tels cas, l'insuffisance des temps de calculs autorisés engendre un mauvais fonctionnement de la simulation en temps réel. Dans ces conditions, trois solutions sont classiquement mises en oeuvre afin de contourner le problème.

La première solution consiste à simplifier le modèle et donc les équations utilisées afin d'accélérer les calculs réalisés à chaque itération. De telles simplifications entraînent donc une diminution du temps de calcul. Cependant, cette première solution entraîne une perte de précision dans les calculs.

La deuxième solution consiste à limiter le nombre d'itérations autorisé à chaque période d'échantillonnage afin d'assurer le respect des contraintes de temps réel. Cependant, cette deuxième solution implique également une importante perte de précision dans les calculs. En effet, les valeurs d'efforts utilisées pour la simulation ne résultent pas nécessairement d'un calcul ayant convergé et ne sont donc pas nécessairement représentatives de la réalité.

La troisième solution consiste à paralléliser des calculs internes au modèle ou à paralléliser les appels au modèle si celui-ci doit être appelé plusieurs fois comme c'est le cas pour le modèle du pneumatique qui est appelé quatre fois pour un véhicule à quatre roues. Cette solution utilise la puissance de calcul des ordinateurs actuels afin de satisfaire les contraintes de temps réel sans détériorer la précision du modèle. Cependant, paralléliser des calculs nécessite de créer et de gérer des tâches informatiques supplémentaires. Cette gestion est dépendante des technologies informatiques utilisées dans les environnements hôtes de la simulation. Il est donc possible de garantir un bon fonctionnement des calculs parallélisés uniquement en maîtrisant la gestion informatique de l'environnement hôte de la simulation. Cette troisième solution n'est donc pas applicable pour un modèle tel que TameTire conçu pour être un logiciel prêt à l'emploi dans des environnements de simulation divers gérés par un tiers.

### 3. Objectifs de l'invention

L'invention propose une solution visant à pallier les inconvénients précités. Un objectif de l'invention est de proposer un procédé de simulation permettant de satisfaire les contraintes de temps réel avec une bonne précision dans les résultats de la simulation, quel que soit l'environnement de simulation utilisé.

### 4. Résumé de l'invention

L'invention concerne un procédé de simulation de l'évolution temporelle d'un système physique donnant en temps réel l'état de ce système, comme défini dans la revendication indépendante 1 ci-jointe.

Selon une réalisation particulière de l'invention, si la convergence de l'algorithme n'est pas atteinte à l'issue de la dernière itération dans la période courante, la valeur de la variable estimée prise en compte dans la mise à jour de l'état du système est la valeur de la variable estimée à la période précédant la période courante. Dans la mesure où les variations de la variable estimée sont peu importantes d'une période à l'autre, ceci permet d'avoir une bonne approximation de la variable estimée en attendant la convergence de l'algorithme.

Selon une réalisation particulière de l'invention, un nombre maximum de périodes pour converger est défini et l'algorithme itératif se poursuit à la période suivante si le nombre maximum de périodes pour converger n'est pas atteint. Ceci permet de garantir une fréquence de rafraîchissement de la variable estimée assurant une bonne précision de la simulation.

Selon une réalisation particulière de l'invention, un nombre maximum d'itérations par période est défini et l'algorithme itératif réalise un nombre d'itérations dans chaque période inférieur ou égal au nombre maximum d'itérations par période. Ceci permet de garantir que le nombre maximum d'itérations pouvant être calculées dans une période de temps n'est jamais dépassé.

Selon une réalisation particulière de l'invention, le nombre maximum de périodes pour converger est paramétrable. Ceci permet de s'adapter à différents environnements de simulation.

Selon une réalisation particulière de l'invention, le nombre maximum d'itérations par période est paramétrable. Ceci permet de s'adapter à différents environnements de simulation.

Selon une réalisation particulière de l'invention, le procédé comporte un paramétrage du nombre d'itérations nécessaire pour converger. Ceci permet de régler par exemple le nombre maximum d'itérations par période et le nombre maximum de périodes pour converger afin de répartir de manière homogène la convergence sur plusieurs pas de temps.

Selon une réalisation particulière de l'invention, l'atteinte de la convergence de l'algorithme est déterminée par un critère de convergence et en ce que le critère de convergence est adapté en fonction du nombre d'itérations nécessaire pour converger.

Selon une réalisation particulière de l'invention, l'atteinte de la convergence de l'algorithme est déterminée par un critère de convergence et en ce que le critère de convergence détermine que la convergence est atteinte si l'écart entre deux valeurs calculées pour la variable estimée lors des deux dernières itérations de l'algorithme est inférieur à un seuil.

Selon une réalisation particulière de l'invention, le procédé comporte une sauvegarde des grandeurs impliquées dans l'algorithme itératif.

Selon une réalisation particulière de l'invention, le nombre maximum de périodes pour converger est défini de manière que la fréquence de mise à jour de la variable estimée est supérieure à deux fois la fréquence maximale de variation de la grandeur représentée par la variable estimée. Ceci permet de respecter le critère de Shannon afin d'obtenir une bonne précision pour la variable estimée.

Selon une réalisation particulière, le procédé simule le comportement d'un pneu.

L'invention concerne également un procédé de simulation du comportement physique d'un pneu équipant un véhicule, la bande de roulement du pneu présentant avec le sol une aire de contact incluant une zone de contact adhérent et une zone de contact glissant, la zone de contact adhérent étant séparée de la zone de contact glissant par une frontière d'abscisse supposée unique, le procédé donnant en temps réel l'état d'un système modélisant le comportement physique du pneu, l'état du système étant défini par un ensemble de variables mises à jour périodiquement selon une période prédéterminée, le procédé comportant :
- une mise à jour de la valeur d'au moins une des variables, dite variable d'entrée, dépendant des conditions physiques de roulement et d'utilisation du pneu, et
- une estimation de la valeur d'au moins une des variables, dite variable estimée, par convergence d'un algorithme itératif ayant comme donnée d'entrée l'au moins une variable d'entrée, la variable estimée étant :
   ∘ l'intensité des efforts longitudinaux transmis par le pneu entre le sol et le véhicule,
   ∘ l'intensité des efforts transversaux transmis par le pneu entre le sol et le véhicule,
   ∘ le moment du couple d'auto-alignement s'exerçant sur le pneu au centre de l'interface avec le sol autour d'un axe vertical, ou
   ∘ l'abscisse de la frontière entre les zones de contacts glissant et adhérent,
procédé dans lequel, si la convergence de l'algorithme n'est pas atteinte à l'issue de la dernière itération dans une période dite courante, l'algorithme itératif se poursuit à la période suivante en repartant de la dernière itération de la période courante.

### 5. Liste des figures

D'autres caractéristiques et avantages innovants ressortiront de la description ci-après, fournie à titre indicatif et nullement limitatif, en référence aux dessins annexés, dans lesquels :
- La figure 1a est un graphique représentant la convergence d'une variable estimée sur une seule période d'échantillonnage ;
- La figure 1b est un graphique représentant la convergence d'une variable estimée sur plusieurs périodes d'échantillonnage selon un mode de réalisation de l'invention ;
- La figure 2 est un graphique représentant de manière superposée l'évolution temporelle d'une variable estimée avec une contrainte de temps réel selon un mode de réalisation de l'invention et l'évolution temporelle de la même variable estimée sans contrainte de temps réel ;

- Les figures 3a et 3b montrent les résultats et les temps de calcul de deux simulations respectivement sans et avec possibilité de convergence sur plusieurs pas de temps ;
- La figure 4 est un organigramme d'un procédé selon un mode de réalisation de l'invention ;

### 6. Description détaillée

Le procédé décrit se situe dans le contexte d'une simulation de l'évolution temporelle d'un système physique donnant en temps réel l'état de ce système. L'état du système est défini par un ensemble de variables associées à des données physiques du système. Les variables sont mises à jour périodiquement selon une période prédéterminée.

Dans le cadre du procédé, le calcul d'au moins une des variables du système, dite variable estimée, nécessite la résolution d'équations au moyen de méthodes de calcul non-linéaires fondées sur la convergence d'un algorithme itératif. L'algorithme itératif permet de résoudre les équations par approximations successives de la variable estimée. Les équations définissent les relations entre la variable estimée et au moins une des autres variables de l'état du système, dite variable d'entrée.

Le procédé comprend donc :
- une mise à jour de la variable d'entrée et
- une estimation de la valeur de la variable estimée, par convergence d'un algorithme itératif ayant comme donnée d'entrée l'au moins une variable d'entrée.

La variable d'entrée est par exemple obtenue par calcul ou par une acquisition. L'acquisition est par exemple reçue d'un capteur mesurant la valeur de la variable d'entrée.

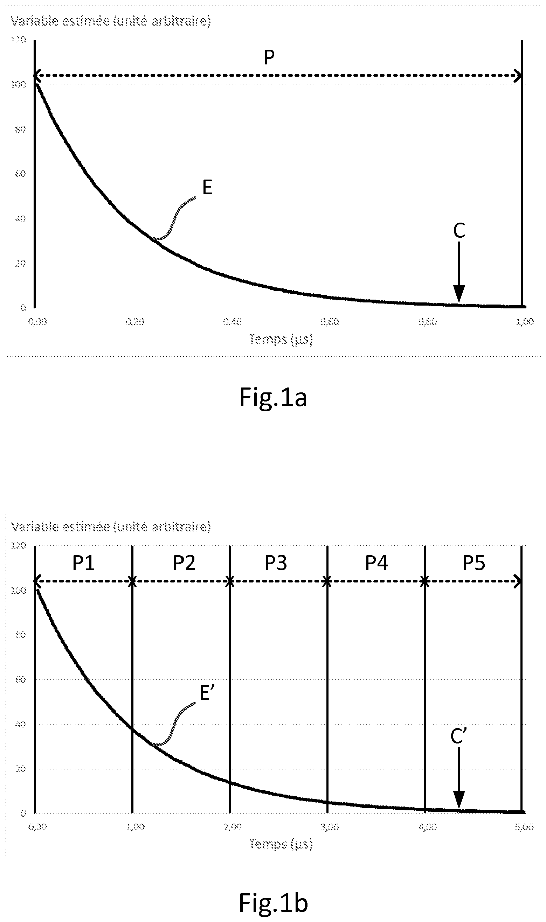

La figure 1a est un graphique représentant un cas classique de convergence d'une variable estimée E sur une seule période P d'échantillonnage.

L'atteinte de la convergence de l'algorithme est déterminée par un critère de convergence. Dans l'exemple, le critère de convergence détermine que la convergence est atteinte si l'écart entre deux valeurs calculées pour la variable estimée lors des deux dernières itérations de l'algorithme est inférieur à un seuil. Sur le graphique de la figure 1a, la convergence est atteinte au point C.

Dans certains cas, la convergence n'est pas atteinte à l'issue de la dernière itération dans une période dite courante, la période courante ayant une durée inférieure ou égale à la période prédéterminée. C'est par exemple le cas à la figure 1b représentant la convergence d'une variable estimée E' sur plusieurs périodes P1 à P5 d'échantillonnage selon un mode de réalisation de l'invention. En effet, à l'issue de la période P1, le critère de convergence n'est pas satisfait.

Le procédé décrit propose alors de poursuivre l'algorithme itératif à la période suivante P2 en repartant de la dernière itération de la période courante P1. A l'issue de la dernière itération dans la période P2, la convergence n'est pas atteinte, ainsi, l'algorithme itératif se poursuit à la période P3 en repartant de la dernière itération de la période P2. De même la convergence n'est toujours pas atteinte dans les périodes P3 et P4, l'algorithme itératif se poursuit donc à la période P4 en repartant de la dernière itération de la période P3 et à la période P5 en repartant de la dernière itération de la période P4. C'est seulement dans la période P5 que la convergence est atteinte au point C' .

Selon un exemple plus spécifique, le procédé est un procédé de simulation du comportement physique d'un pneu équipant un véhicule. Le procédé est par exemple implémenté dans un simulateur de conduite. Ainsi, le procédé donne en temps réel l'état d'un système modélisant le comportement physique du pneu, l'état du système étant défini par un ensemble de variables mises à jour périodiquement selon une période.

La bande de roulement du pneu présente avec le sol une aire de contact incluant une zone de contact adhérent et une zone de contact glissant. La zone de contact adhérent est séparée de la zone de contact glissant par une frontière d'abscisse b supposée unique.

Le procédé comprend :
- une mise à jour de la valeur d'au moins une des variables, dite variable d'entrée, dépendant des conditions physiques de roulement et d'utilisation du pneu, et
- une estimation de la valeur d'au moins une des variables, dite variable estimée, par convergence d'un algorithme itératif ayant comme donnée d'entrée l'au moins une variable d'entrée.

La variable estimée est par exemple :
∘ l'intensité des efforts longitudinaux (Fx) transmis par le pneu entre le sol et le véhicule,
∘ l'intensité des efforts transversaux (Fy) transmis par le pneu entre le sol et le véhicule,
∘ le moment du couple d'auto-alignement (Mx) s'exerçant sur le pneu au centre de l'interface avec le sol autour d'un axe vertical, ou
∘ l'abscisse (b) de la frontière entre les zones de contacts glissant et adhérent.

Les équations définissant les relations entre les différentes variables de l'état du système sont décrites en détail dans le document brevet FR 2 905 496.

Dans le procédé décrit, si la convergence de l'algorithme n'est pas atteinte à l'issue de la dernière itération dans une période dite courante, l'algorithme itératif se poursuit à la période suivante en repartant de la dernière itération de la période courante.

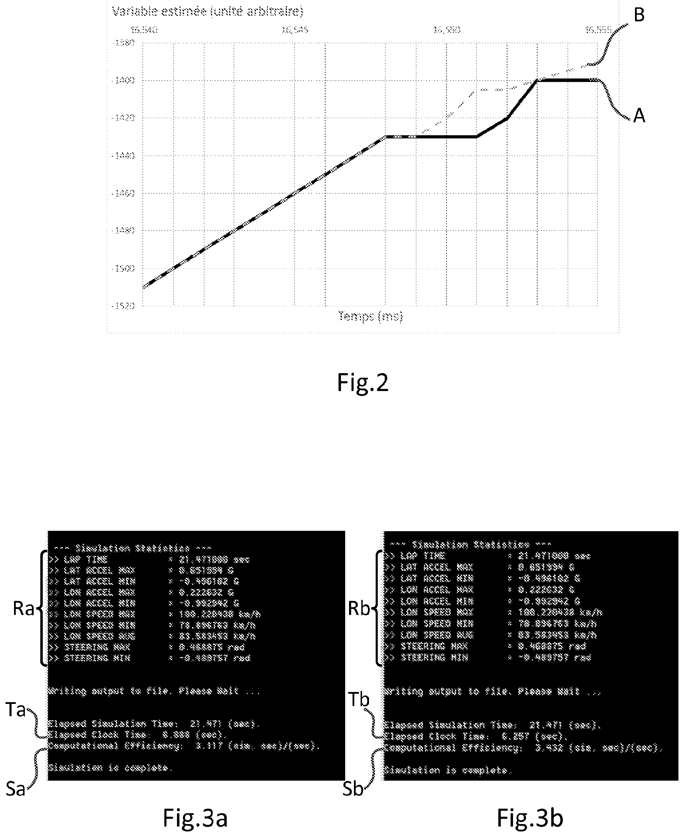

La figure 2 est un graphique représentant de manière superposée :
- courbe A : l'évolution temporelle d'une variable estimée avec une contrainte de temps réel selon un mode de réalisation de l'invention ; et
- courbe B : l'évolution temporelle de la même variable estimée sans contrainte de temps réel.

Pour la courbe A, le respect du temps réel est garanti par un échantillonnage de période 0,001ms. La possibilité de convergence de la variable estimée sur plusieurs périodes d'échantillonnage est implémentée selon un mode de réalisation de l'invention.

Pour la courbe B, le respect du temps réel n'est pas garanti. Ainsi, le temps de calcul nécessaire pour obtenir la courbe B, simulant l'évolution de la variable estimée sur la période de temps allant de 16,540ms à 16,555ms, est supérieur à la durée de cette période de temps. En effet, pour obtenir la valeur de la variable estimée à chaque pas de temps de la période de temps, le programme de la courbe B prend le temps de calcul nécessaire pour obtenir la convergence de la variable estimée. Ce temps de calcul nécessaire peut être supérieur au pas de temps comme nous allons le voir.

Jusqu'au pas de temps 16,549ms les courbes A et B se superposent exactement ce qui signifie que l'algorithme itératif permettant d'obtenir la variable estimée converge en moins de 0,001ms, c'est-à-dire que la convergence de la variable estimée est obtenue dans une seule période d'échantillonnage.

En revanche, au pas de temps 16,550ms, les courbes A et B se séparent. En effet, l'algorithme itératif a besoin de trois pas de temps pour converger. Par conséquent, le programme de la courbe A renvoie aux pas de temps 16,550ms et 16,551ms la dernière valeur de la variable estimée, à savoir -1430 obtenue au pas de temps 16,549ms. Au pas de temps 16,552ms, le programme de la courbe A a obtenu la convergence de la variable estimée et renvoie une valeur de la variable estimée correspondant au pas de temps 16,550ms. La valeur de la variable estimée au pas de temps 16,552ms sur la courbe A est donc égale à la valeur de la variable estimée au pas de temps 16,550ms sur la courbe B, à savoir -1420.

Au pas de temps 16,553ms, l'algorithme itératif permettant d'obtenir la variable estimée a convergé en moins d'une période d'échantillonnage. La valeur de la variable estimée au pas de temps 16, 552ms sur la courbe A est donc égale à la valeur de la variable estimée sur la courbe B, à savoir -1400.

Dans cet exemple, si la convergence de l'algorithme n'est pas atteinte à l'issue de la dernière itération dans la période courante, la valeur de la variable estimée prise en compte dans la mise à jour de l'état du système est la valeur estimée à la période précédant la période courante. En d'autres termes, la variable estimée reste constante le temps d'obtenir la convergence.

Selon une réalisation particulière de l'invention non représentée, si la convergence n'est pas atteinte, l'algorithme itératif se poursuit à la période suivante.

Les figures 3a et 3b montrent les résultats et les temps de calcul de deux simulations respectivement sans et avec possibilité de convergence sur plusieurs pas de temps. Les deux simulations représentent le même système physique. Elles sont lancées sur une machine sans contrainte de temps réel, c'est-à-dire que le temps de calcul peut être plus lent ou plus rapide que le temps réel. Pour chaque pas de temps de la simulation, des valeurs sont calculées pour les différentes variables.

Dans le cas de la figure 3a, la possibilité de convergence sur plusieurs pas de temps est implémentée selon un mode de réalisation de l'invention. En revanche, dans le cas de la figure 3b, les variables d'un pas de temps ne sont calculées qu'une fois que toutes les variables du pas de temps précédent sont obtenues, c'est-à-dire qu'une fois que tous les algorithmes du pas de temps précédent ont convergé.

La comparaison des figures 3a et 3b montre que le temps de calcul total de la simulation (Elapsed Clock Time) respectivement Ta et Tb est plus faible à la figure 3a qu'à la figure 3b et par conséquent que l'efficacité de calcul (Computational Efficiency) respectivement Sa et Sb, correspondant à la durée de la période de temps simulée divisée par le temps de calcul, est meilleure à la figure 3a qu'à la figure 3b. La comparaison des figures 3a et 3b montre également que les résultats des deux simulations respectivement Ra et Rb sont identiques (LAP TIME ... STEERING MIN). Ceci met en évidence que l'implémentation de la possibilité de convergence sur plusieurs pas de temps augmente l'efficacité des calculs tout en conservant la précision des résultats.

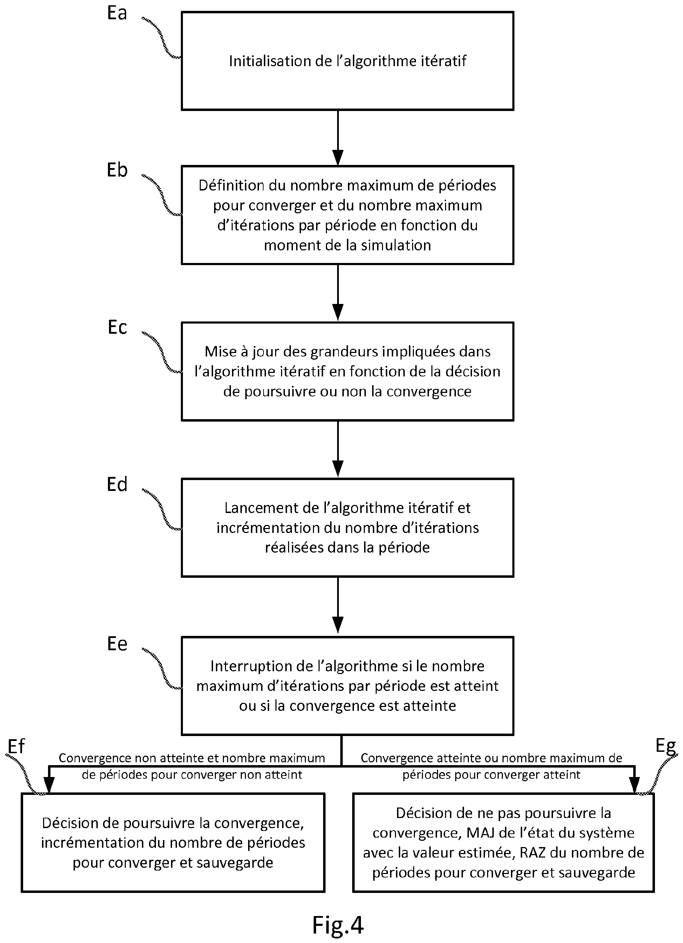

La figure 4 est un organigramme d'un procédé selon un mode de réalisation de l'invention.

Le procédé comporte les étapes suivantes :
- Ea : Initialisation de l'algorithme itératif ;
- Eb : Définition du nombre maximum de périodes pour converger et du nombre maximum d'itérations par période en fonction du moment de la simulation ;
- Ec : Mise à jour des grandeurs impliquées dans l'algorithme itératif en fonction de la décision de poursuivre ou non la convergence ;
- Ed : Lancement de l'algorithme itératif et incrémentation du nombre d'itérations réalisées dans la période ;
- Ee : Interruption de l'algorithme si le nombre maximum d'itérations par période est atteint ou si la convergence est atteinte ;
- Ef : Décision de poursuivre la convergence, incrémentation du nombre de périodes pour converger et sauvegarde ;
- Eg : Décision de ne pas poursuivre la convergence, mise à jour (MAJ) de l'état du système avec la valeur estimée pour la variable estimée, remise à zéro (RAZ) du nombre de périodes pour converger et sauvegarde.

L'étape Ea d'initialisation de l'algorithme itératif permet d'initialiser des éléments de l'algorithme avant de lancer les itérations de l'algorithme dans une période. Par exemple, dans cette étape, les éléments suivants sont initialisés :
- La relation mathématique intervenant dans l'algorithme avec des paramètres par exemple fournis par le reste du modèle ou par l'environnement de simulation,
- Une valeur de départ de la variable estimée pour l'algorithme itératif, par exemple fournie par le reste du modèle ou par l'environnement de simulation,
- La décision de poursuivre ou non la convergence fournie par la sauvegarde des grandeurs impliquées dans l'algorithme réalisée à la période précédente,
- Le nombre maximum de périodes pour converger et le nombre maximum d'itérations par période, par exemple fournis par un réglage de l'utilisateur.

L'étape Eb de définition du nombre maximum de périodes pour converger et du nombre maximum d'itérations par période en fonction du moment de la simulation distingue les deux cas suivants :
- si on est au tout premier instant de simulation, alors on oblige à converger sur un pas de temps avec un nombre important d'itérations autorisé,
- sinon, ce sont les valeurs de nombre maximum de périodes pour converger et de nombre maximum d'itérations par période fournies à l'initialisation de l'algorithme qui sont prises en compte.

L'étape Ec de mise à jour des grandeurs impliquées dans l'algorithme itératif en fonction de la décision de poursuivre ou non la convergence distingue les deux cas suivants :
- si on est dans le cas de la décision de poursuivre la convergence, on charge les grandeurs impliquées dans l'algorithme itératif sauvegardées à savoir :
   - la dernière valeur de la variable estimée,
   - le nombre de périodes de temps ayant déjà été utilisé,
   - l'état de l'algorithme itératif afin de reprendre la convergence là où elle a été arrêtée ;
- si on est dans le cas de la décision de ne pas poursuivre la convergence, on charge la valeur de départ de la variable estimée pour l'algorithme itératif issue de l'étape Ea d'initialisation de l'algorithme itératif.

L'étape Ed de lancement de l'algorithme itératif et d'incrémentation du nombre d'itérations réalisées dans la période correspond à une boucle itérative dans laquelle à chaque itération la valeur de la variable estimée est mise à jour selon X = X + alpha où X est la valeur de la variable estimée à l'itération précédente et alpha est une direction de convergence calculée par l'algorithme en particulier grâce à la relation mathématique issue de l'étape Ea d'initialisation de l'algorithme itératif.

L'étape Ee d'interruption de l'algorithme si le nombre maximum d'itérations par période est atteint ou si la convergence est atteinte permet d'interrompre la boucle itérative si à l'issue d'une itération :
- le nombre maximum d'itérations par période est atteint, ou
- la convergence est atteinte, c'est-à-dire si le critère de convergence est satisfait.

A l'issue de l'étape Ee d'interruption de l'algorithme, on distingue les deux cas suivants :
- si la convergence n'est pas atteinte et que le nombre maximum de périodes pour converger n'est pas atteint, par exemple lorsque l'algorithme a été interrompu parce que le nombre maximum d'itérations par période a été atteint, on passe à l'étape Ef de décision de poursuivre la convergence, d'incrémentation du nombre de périodes pour converger et de sauvegarde ;
- Si la convergence est atteinte ou le nombre maximum de périodes pour converger est atteint, on passe à l'étape Eg de décision de ne pas poursuivre la convergence, de mise à jour de l'état du système avec la valeur estimée pour la variable estimée, de remise à zéro du nombre de périodes pour converger et de sauvegarde.

Dans l'étape Ef de décision de poursuivre la convergence, d'incrémentation du nombre de périodes pour converger et de sauvegarde, les opérations suivantes sont réalisées :
- mise à jour d'un paramètre dédié avec la décision de poursuivre la convergence,
- incrémentation du nombre de périodes pour converger,
- sauvegarde des grandeurs nécessaires à la période temporelle suivante.

Dans l'étape Eg de décision de ne pas poursuivre la convergence, de mise à jour de l'état du système avec la valeur estimée pour la variable estimée, de remise à zéro du nombre de périodes pour converger et de sauvegarde, les opérations suivantes sont réalisées :
- mise à jour d'un paramètre dédié avec la décision de ne pas poursuivre la convergence,
- mise à jour de l'état du système avec la valeur estimée de la variable estimée à la dernière itération de l'algorithme,
- remise à zéro du nombre de périodes pour converger, et
- sauvegarde des grandeurs nécessaires à la période temporelle suivante.

Dans l'exemple du procédé de la figure 4, un nombre maximum de périodes pour converger est défini et l'algorithme itératif se poursuit à la période suivante si le nombre maximum de périodes pour converger n'est pas atteint. Le nombre maximum de périodes pour converger est paramétrable et est défini par un réglage manuel de l'utilisateur.

De même, un nombre maximum d'itérations par période est défini et l'algorithme itératif réalise un nombre d'itérations dans chaque période inférieur ou égal au nombre maximum d'itérations par période. Le nombre maximum d'itérations par période est également paramétrable et est défini par un réglage manuel de l'utilisateur.

Dans une réalisation particulière, le paramétrage du nombre maximum de périodes pour converger comporte une borne supérieure de sorte que le nombre maximum de périodes pour converger est nécessairement défini de manière que la fréquence de mise à jour de la variable estimée est supérieure à deux fois la fréquence maximale de variation de la grandeur représentée par la variable estimée. Ceci permet de respecter le critère de Shannon et de garantir que les variations de la variable estimée sont représentatives des variations de la grandeur représentée.

L'invention est décrite dans ce qui précède à titre d'exemple. Il est entendu que la personne de l'art est à même de réaliser différentes variantes de réalisation de l'invention, en associant par exemple les différentes caractéristiques ci-dessus prises seules ou en combinaison, sans pour autant sortir du cadre de l'invention revendiquée.

## Revendications

1. Procédé de simulation du comportement physique d'un pneu équipant un véhicule, la bande de roulement du pneu présentant avec le sol une aire de contact incluant une zone de contact adhérent et une zone de contact glissant, la zone de contact adhérent étant séparée de la zone de contact glissant par une frontière d'abscisse (b) supposée unique, le procédé donnant en temps réel l'état d'un système modélisant le comportement physique du pneu, l'état du système étant défini par un ensemble de variables mises à jour périodiquement selon une période (P) prédéterminée, le procédé comportant :
- une mise à jour de la valeur d'au moins une des variables, dite variable d'entrée, dépendant des conditions physiques de roulement et d'utilisation du pneu, et
- une estimation de la valeur d'au moins une des variables, dite variable estimée, par convergence d'un algorithme itératif ayant comme donnée d'entrée l'au moins une variable d'entrée, la variable estimée étant :
∘ l'intensité des efforts longitudinaux (Fx) transmis par le pneu entre le sol et le véhicule,
∘ l'intensité des efforts transversaux (Fy) transmis par le pneu entre le sol et le véhicule,
∘ le moment du couple d'auto-alignement (Mx) s'exerçant sur le pneu au centre de l'interface avec le sol autour d'un axe vertical, ou
∘ l'abscisse (b) de la frontière entre les zones de contacts glissant et adhérent,
le procédé étant **caractérisé en ce que**, si la convergence de l'algorithme n'est pas atteinte à l'issue de la dernière itération dans une période dite courante, l'algorithme itératif se poursuit à la période suivante en repartant de la dernière itération de la période courante.

2. Procédé de simulation selon la revendication 1 **caractérisé en ce que**, si la convergence de l'algorithme n'est pas atteinte à l'issue de la dernière itération dans la période courante, la valeur de la variable estimée prise en compte dans la mise à jour de l'état du système est la valeur estimée à la période précédant la période courante.

3. Procédé de simulation selon l'une quelconque des revendications précédentes, **caractérisé en ce qu'**un nombre maximum de périodes pour converger est défini et **en ce que** l'algorithme itératif se poursuit à la période suivante si le nombre maximum de périodes pour converger n'est pas atteint.

4. Procédé de simulation selon l'une quelconque des revendications précédentes, **caractérisé en ce qu'**un nombre maximum d'itérations par période est défini et **en ce que** l'algorithme itératif réalise un nombre d'itérations dans chaque période inférieur ou égal au nombre maximum d'itérations par période.

5. Procédé de simulation selon la revendication 3 **caractérisé en ce que** le nombre maximum de périodes pour converger est paramétrable.

6. Procédé de simulation selon la revendication 4 **caractérisé en ce que** le nombre maximum d'itérations par période est paramétrable.

7. Procédé de simulation selon la revendication 6, **caractérisé en ce que** l'atteinte de la convergence de l'algorithme est déterminée par un critère de convergence et **en ce que** le critère de convergence est adapté en fonction du nombre d'itérations nécessaire pour converger.

8. Procédé de simulation selon l'une quelconque des revendications précédentes, **caractérisé en ce que** l'atteinte de la convergence de l'algorithme est déterminée par un critère de convergence et **en ce que** le critère de convergence détermine que la convergence est atteinte si l'écart entre deux valeurs calculées pour la variable estimée lors des deux dernières itérations de l'algorithme est inférieur à un seuil.

9. Procédé de simulation selon l'une quelconque des revendications précédentes **caractérisé en ce qu'**il comporte une sauvegarde des grandeurs impliquées dans l'algorithme itératif.

## Patentansprüche

1. Verfahren zur Simulation des physikalischen Verhaltens eines Reifens, mit dem ein Fahrzeug ausgerüstet ist, wobei die Lauffläche des Reifens mit dem Boden eine Kontaktfläche aufweist, die einen Haftkontaktbereich und einen Gleitkontaktbereich umfasst, wobei der Haftkontaktbereich von dem Gleitkontaktbereich durch eine als einzig angenommene Grenze einer Abszisse (b) getrennt ist, wobei das Verfahren den Zustand eines Systems, das das physikalische Verhalten des Reifens modelliert, in Echtzeit angibt, wobei der Zustand des Systems durch einen Satz Variablen definiert wird, die gemäß einer vorbestimmten Periode (P) periodisch aktualisiert werden, wobei das Verfahren Folgendes umfasst:
- eine Aktualisierung des Werts von mindestens einer der Variablen, als Eingangsvariable bezeichnet, die von den physikalischen Fahr- und Nutzungsbedingungen des Reifens abhängt, und
- eine Schätzung des Werts von mindestens einer der Variablen, als geschätzte Variable bezeichnet, durch Konvergenz eines iterativen Algorithmus, der als Eingangsdatenelement die mindestens eine Eingangsvariable aufweist, wobei die geschätzte Variable Folgendes ist:
∘ die Stärke der Längskräfte (Fx), die durch den Reifen zwischen dem Boden und dem Fahrzeug übertragen werden,
∘ die Stärke der Seitenkräfte (Fy), die durch den Reifen zwischen dem Boden und dem Fahrzeug übertragen werden,
∘ das Selbstausrichtungsmoment (Mx), das in der Mitte der Grenzfläche zu dem Boden um eine vertikale Achse auf den Reifen wirkt, oder
∘ die Abszisse (b) der Grenze zwischen dem Gleit- und dem Haftkontaktbereich,
wobei das Verfahren **dadurch gekennzeichnet ist, dass**, wenn die Konvergenz des Algorithmus nach Abschluss der letzten Iteration in einer sogenannten aktuellen Periode nicht erreicht wird, sich der iterative Algorithmus in der nachfolgenden Periode fortsetzt, indem er an der letzten Iteration der aktuellen Periode neu startet.

2. Simulationsverfahren nach Anspruch 1, **dadurch gekennzeichnet, dass**, wenn die Konvergenz des Algorithmus nach Abschluss der letzten Iteration in der aktuellen Periode nicht erreicht wird, der Wert der geschätzten Variablen, der bei der Aktualisierung des Zustands des Systems berücksichtigt wird, derjenige Wert ist, der in der Periode geschätzt wurde, die der aktuellen Periode vorausgeht.

3. Simulationsverfahren nach einem beliebigen der vorhergehenden Ansprüche, **dadurch gekennzeichnet, dass** eine maximale Anzahl von Perioden zum Konvergieren definiert wird und dass sich der iterative Algorithmus in der nachfolgenden Periode fortsetzt, wenn die maximale Anzahl von Perioden zum Konvergieren nicht erreicht ist.

4. Simulationsverfahren nach einem beliebigen der vorhergehenden Ansprüche, **dadurch gekennzeichnet, dass** eine maximale Anzahl von Iterationen pro Periode definiert wird und dass der iterative Algorithmus in jeder Periode eine Anzahl von Iterationen durchführt, die kleiner als oder gleich der maximalen Anzahl von Iterationen pro Periode ist.

5. Simulationsverfahren nach Anspruch 3, **dadurch gekennzeichnet, dass** die maximale Anzahl von Perioden zum Konvergieren parametrierbar ist.

6. Simulationsverfahren nach Anspruch 4, **dadurch gekennzeichnet, dass** die maximale Anzahl von Iterationen pro Periode parametrierbar ist.

7. Simulationsverfahren nach Anspruch 6, **dadurch gekennzeichnet, dass** das Erreichen der Konvergenz des Algorithmus durch ein Konvergenzkriterium bestimmt wird und dass das Konvergenzkriterium in Abhängigkeit von der Anzahl von Iterationen, die für das Konvergieren notwendig ist, angepasst wird.

8. Simulationsverfahren nach einem beliebigen der vorhergehenden Ansprüche, **dadurch gekennzeichnet, dass** das Erreichen der Konvergenz des Algorithmus durch ein Konvergenzkriterium bestimmt wird und dass das Konvergenzkriterium bestimmt, dass die Konvergenz erreicht ist, wenn die Abweichung zwischen zwei Werten, die während der letzten zwei Iterationen des Algorithmus für die geschätzte Variable berechnet wurden, kleiner als ein Schwellenwert ist.

9. Simulationsverfahren nach einem beliebigen der vorhergehenden Ansprüche, **dadurch gekennzeichnet, dass** es eine Speicherung der Größen, die an dem iterativen Algorithmus beteiligt sind, umfasst.

## Claims

1. Method for simulating the physical behavior of a tire fitted on a vehicle, the tread of the tire having a contact area with the ground that includes an adherent contact zone and a sliding contact zone, the adherent contact zone being separated from the sliding contact zone by a boundary of abscissa (b) assumed to be unique, the method giving the real-time state of a system modeling the physical behavior of the tire, the state of the system being defined by a set of variables periodically updated according to a predetermined period (P), the method comprising :
- updating the value of at least one of the variables, referred to as the input variable, depending on the tire's physical rolling and usage conditions, and
- estimating of the value of at least one of the variables, called the estimated variable, by convergence of an iterative algorithm having as input data the at least one input variable, the estimated variable being:
∘ the magnitude of the longitudinal forces (Fx) transmitted by the tire between the ground and the vehicle,
∘ the magnitude of the transverse forces (Fy) transmitted by the tire between the ground and the vehicle,
∘ the moment of the self-aligning torque (Mx) acting on the tire at the center of the interface with the ground about a vertical axis, or
∘ the abscissa (b) of the border between the regions of sliding and gripping contact,
the method being **characterized in that**, when convergence of the algorithm is not reached at the end of the last iteration in a so-called current period, the iterative algorithm continues in the next period, starting again from the last iteration of the current period.

2. Simulating method according to Claim 1, **characterized in that**, if the convergence of the algorithm is not reached at the end of the last iteration in the current period, the value of the estimated variable taken into account in the update of the state of the system is the value estimated at the period preceding the current period.

3. Simulating method according to any of the preceding claims, **characterized in that** a maximum number of periods to converge is defined and **in that** the iterative algorithm continues in the following period when the maximum number of periods to converge is not reached.

4. Simulating method according to any of the preceding claims, **characterized in that** a maximum number of iterations per period is defined and **in that** the iterative algorithm performs a number of iterations in each period less than or equal to the maximum number of iterations per period.

5. Simulating method according to claim 3, **characterized in that** the maximum number of periods to converge is configurable.

6. Simulating method according to Claim 4, **characterized in that** the maximum number of iterations per period is configurable.

7. Simulating method according to claim 6, **characterized in that** the attainment of convergence of the algorithm is determined by a convergence criterion and **in that** the convergence criterion is adapted as a function of the number of iterations required to converge.

8. Simulating method according to any one of the preceding claims, **characterized in that** the attainment of convergence of the algorithm is determined by a convergence criterion and **in that** the convergence criterion determines that convergence is attained when the deviation between two values calculated for the estimated variable during the last two iterations of the algorithm is less than a threshold.

9. Simulating method according to any one of the preceding claims, **characterized in that** it comprises saving the quantities involved in the iterative algorithm.
